# EUROPEAN PATENT APPLICATION

(11) **EP 4 800 835 A1**
(43) Date of publication of application: **02.09.2026**
(21) Application number: 24881997.1
(22) Date of filing: 20.08.2024
(51) Int. Cl.: H01P 1/00, H05K 1/02, H05K 3/46

(54) **WIRING STRUCTURE FOR HIGH-FREQUENCY SIGNALS AND POWER COMBINATION/DISTRIBUTION DEVICE**

(30) Priority: 24.10.2023 JP 2023182445
(71) Applicant: Fujikura Ltd., Tokyo 135-8512 (JP)
(72) Inventor: UEMICHI, Yusuke, Sakura-shi, Chiba 285-8550 (JP)
(74) Representative: Lavoix
(86) International application number: PCT/JP2024/029429
(87) International publication number: WO 2025/088880

(57) **Abstract**

A wiring structure for a high-frequency signal includes a first signal line configured to transmit a first high-frequency signal, and a second signal line configured to transmit a second high-frequency signal different from the first high-frequency signal, in which a part where the first signal line intersects the second signal line in a plan view is an intersection portion, the first signal line and the second signal line are formed on different layers in the intersection portion, and a first ground portion including the intersection portion in a plan view and disposed between the first signal line and the second signal line in a plan view direction is provided in the intersection portion.

## Description

### TECHNICAL FIELD

The present invention relates to a wiring structure for a high-frequency signal and a power combination/distribution device.

Priority is claimed on Japanese Patent Application No. 2023-182445, filed October 24, 2023, the content of which is incorporated herein by reference.

### BACKGROUND ART

Patent Document 1 below discloses a power combiner that distributes or combines high-frequency power used in a communication device or the like. The power combiner combines in phase a plurality of high-frequency powers individually input from a plurality of input ports and outputs the combined high-frequency power from an output port.

### Citation List

### Patent Document

Patent Document 1: Japanese Unexamined Patent Application, First Publication No. 2011-135232

### SUMMARY OF INVENTION

### Technical Problem

In a communication device using a phased array that uses a quasi-millimeter wave band, a millimeter wave band, or the like, there is a case where both a signal of a vertical polarization component (V) and a signal of a horizontal polarization component (H) of high-frequency power are used. The phased array includes a plurality of front ends (FEs) and a plurality of power combination/distribution circuits that combine or distribute signals of the front ends.

By the way, there is a case where, when the number of front ends increases, the number of signal lines from the front end to a power distribution/combination circuit also increases, and these signal lines may be mixed to intersect each other in a plan view. Since the signal of the vertical polarization component and the signal of the horizontal polarization component of the high-frequency power have different types of information, in a case where crosstalk occurs between the lines in an intersection portion of the signal lines, it may cause a communication error.

The present invention is made in view of the above-described problem, and an object of the present invention is to suppress crosstalk in an intersection portion of two signal lines that transmit high-frequency signals different from each other.

### Solution to Problem

A wiring structure for a high-frequency signal according to a first aspect of the present invention includes a first signal line configured to transmit a first high-frequency signal, and a second signal line configured to transmit a second high-frequency signal different from the first high-frequency signal, in which a part where the first signal line intersects the second signal line in a plan view is an intersection portion, the first signal line and the second signal line are formed on different layers in the intersection portion, and a first ground portion including the intersection portion in a plan view and disposed between the first signal line and the second signal line in a plan view direction is provided in the intersection portion.

According to the first aspect of the present invention, the first signal line and the second signal line that transmit high-frequency signals different from each other are disposed in the intersection portion with the first ground portion including the intersection portion and interposed therebetween in a plan view direction. The first ground portion serves as a shield that suppresses crosstalk between the first signal line and the second signal line in an intersection portion of the first signal line and the second signal line.

According to a second aspect of the present invention, in the wiring structure for a high-frequency signal according to the first aspect, the first high-frequency signal may be one of a signal of a vertical polarization component and a signal of a horizontal polarization component, and the second high-frequency signal may be the other of the signal of the vertical polarization component and the signal of the horizontal polarization component.

According to a third aspect of the present invention, the wiring structure for a high-frequency signal according to the first aspect or the second aspect may further include conductor layers including four layers, in which the conductor layers may include a first layer, a second layer, a third layer, and a fourth layer which are stacked in this order, the first ground portion may be provided on the third layer, the first signal line may be provided on the second layer in the intersection portion, the second signal line may be provided on the fourth layer in the intersection portion, and a second ground portion including the intersection portion may be provided on the first layer in a plan view.

According to a fourth aspect of the present invention, in the wiring structure for a high-frequency signal according to the third aspect, the first signal line may include a second layer first signal line provided on the second layer, a set of third layer first signal lines provided on the third layer, and a first connection via configured to connect each of both end portions of the second layer first signal line and an end portion of each of the set of third layer first signal lines on an intersection portion side.

According to a fifth aspect of the present invention, in the wiring structure for a high-frequency signal according to the fourth aspect, the second layer first signal line may extend in a direction orthogonal to a direction in which the set of third layer first signal lines extends in a plan view.

According to a sixth aspect of the present invention, in the wiring structure for a high-frequency signal according to the fourth aspect or the fifth aspect, a third ground portion configured to surround the end portion of each of the set of third layer first signal lines on the intersection portion side in a plan view may be provided on the third layer.

According to a seventh aspect of the present invention, in the wiring structure for a high-frequency signal according to any one of the fourth aspect to the sixth aspect, a pair of first outside lines may be provided on both sides of the first signal line, and the first outside lines may include a pair of second layer first outside lines provided on both sides of the second layer first signal line on the second layer, a set of third layer first outside lines provided in pairs on both sides of each of the set of third layer first signal lines on the third layer, and a second connection via configured to connect each of both end portions of the second layer first outside lines and an end portion of each of the set of third layer first outside lines on the intersection portion side.

According to an eighth aspect of the present invention, the wiring structure for a high-frequency signal according to the seventh aspect may further include a third connection via configured to connect the second layer first outside line and the third layer; and a fourth connection via configured to connect the second layer first outside line and the first layer, in which at least part of the second layer first signal line may be disposed in a space surrounded by the first layer, the third layer, the second layer first outside line, the third connection via, and the fourth connection via.

According to a ninth aspect of the present invention, a power combination/distribution device includes the wiring structure for a high-frequency signal according to any one of the first aspect to the eighth aspect, and a first power combination/distribution circuit including the first signal line intersecting the second signal line and the first signal line not intersecting the second signal line by the wiring structure.

According to a tenth aspect of the present invention, a power combination/distribution device includes the wiring structure for a high-frequency signal according to any one of the fourth aspect to the eighth aspect, and a first power combination/distribution circuit including the first signal line intersecting the second signal line and the first signal line not intersecting the second signal line by the wiring structure, in which the second layer first signal line, the set of third layer first signal lines, and the first connection via are provided also in the first signal line not intersecting the second signal line.

According to an eleventh aspect of the present invention, in the wiring structure for a high-frequency signal according to any one of the third aspect to the eighth aspect, the second signal line may include a fourth layer second signal line provided on the fourth layer, a set of third layer second signal lines provided on the third layer, and fifth connection vias configured to connect each of both end portions of the fourth layer second signal line and an end portion of each of the set of third layer second signal lines on an intersection portion side.

According to a twelfth aspect of the present invention, in the wiring structure for a high-frequency signal according to the eleventh aspect, a fourth ground portion configured to surround the end portion of each of the set of third layer second signal lines on the intersection portion side in a plan view may be provided on the third layer.

According to a thirteenth aspect of the present invention, in the wiring structure for a high-frequency signal according to the eleventh aspect or the twelfth aspect, a pair of second outside lines may be provided on both sides of the second signal line, and the second outside lines may include a pair of fourth layer second outside lines provided on both sides of the fourth layer second signal line on the fourth layer, a set of third layer second outside lines provided in pairs on both sides of each of the set of third layer second signal lines on the third layer, and a sixth connection via configured to connect each of both end portions of the fourth layer second outside lines and the end portion of each of the set of third layer second outside lines on the intersection portion side.

According to a fourteenth aspect of the present invention, in the wiring structure for a high-frequency signal according to the thirteenth aspect, a fourth ground portion configured to surround the end portion of each of the set of third layer second signal lines on the intersection portion side in a plan view may be provided on the third layer, the sixth connection via may be configured to connect the fourth layer second outside line and the fourth ground portion, and the fourth ground portion, the fourth layer second outside line, and the sixth connection via may be disposed around at least part of the fourth layer second signal line.

According to a fifteenth aspect of the present invention, a power combination/distribution device may include the wiring structure for a high-frequency signal according to any one of the first to eighth aspects and the eleventh to fourteenth aspects, and a second power combination/distribution circuit including the second signal line intersecting the first signal line and the second signal line not intersecting the first signal line by the wiring structure.

According to a sixteenth aspect of the present invention, a power combination/distribution device may include the wiring structure for a high-frequency signal according to any one of the eleventh aspect to the fourteenth aspect, and a second power combination/distribution circuit including the second signal line intersecting the first signal line and the second signal line not intersecting the first signal line by the wiring structure, in which the fourth layer second signal line, the set of third layer second signal lines, and the fifth connection via may be provided also in the second signal line not intersecting the first signal line.

According to a seventeenth aspect of the present invention, in the wiring structure for a high-frequency signal according to any one of the third to eighth aspects and the eleventh to fourteenth aspects, the fourth layer may have a first part disposed on one side of the intersection portion with the intersection portion interposed therebetween in a plan view, and a second part disposed on another side of the intersection portion with the intersection portion interposed therebetween in the plan view.

According to an eighteenth aspect of the present invention, the wiring structure for a high-frequency signal according to the seventeenth aspect may further include a connection portion configured to connect the first part and the second part at a position not overlapping the intersection portion in a plan view.

### Advantageous Effects of Invention

According to an aspect of the present invention, it is possible to suppress crosstalk in an intersection portion of two signal lines that transmit high-frequency signals different from each other.

### BRIEF DESCRIPTION OF DRAWINGS

[FIG. 1] A schematic plan view of a power combination/distribution device according to a first embodiment.
[FIG. 2] A plan view showing a wiring structure for a high-frequency signal according to the first embodiment.
[FIG. 3] A plan view showing a first layer of the wiring structure for a high-frequency signal according to the first embodiment.
[FIG. 4] A plan view showing a second layer of the wiring structure for a high-frequency signal according to the first embodiment.
[FIG. 5] A plan view showing a third layer of the wiring structure for a high-frequency signal according to the first embodiment.
[FIG. 6] A plan view showing a fourth layer of the wiring structure for a high-frequency signal according to the first embodiment.
[FIG. 7] A cross-sectional view taken along line VII-VII shown in FIG. 2.
[FIG. 8] A cross-sectional view taken along line VIII-VIII shown in FIG. 2.
[FIG. 9] A cross-sectional view taken along line IX-IX shown in FIG. 2.
[FIG. 10] A cross-sectional view taken along line X-X shown in FIG. 2.
[FIG. 11] A perspective view of the wiring structure for high-frequency signal according to the first embodiment.
[FIG. 12] A schematic plan view of a power combination/distribution device according to a second embodiment.
[FIG. 13] A perspective view showing a crossover structure of a second signal line according to the second embodiment.
[FIG. 14] A perspective view showing a cross-under structure of a first signal line according to the second embodiment.
[FIG. 15] A perspective view of a wiring structure for a high-frequency signal according to a third embodiment.
[FIG. 16] A perspective view of a wiring structure for a high-frequency signal according to a modification example of the third embodiment.
[FIG. 17] A schematic plan view of a power combination/distribution device according to another modification example.

### DESCRIPTION OF EMBODIMENTS

Hereinafter, a wiring structure for a high-frequency signal and a power combination/distribution device according to an embodiment of the present invention will be described with reference to the drawings.

### (First Embodiment)

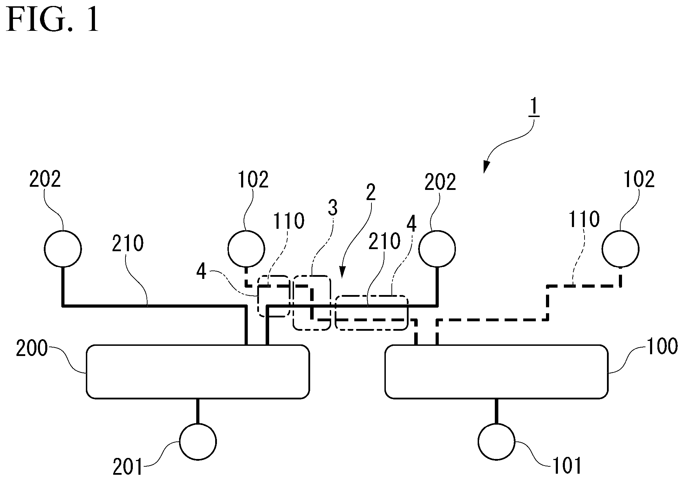

FIG. 1 is a schematic plan view of a power combination/distribution device 1 according to a first embodiment.

The power combination/distribution device 1 shown in FIG. 1 includes a first power combination/distribution circuit 100 that combines or distributes a signal (hereinafter, referred to as a first high-frequency signal) of a vertical polarization component (V) of high-frequency power, and a second power combination/distribution circuit 200 that combines or distributes a signal (hereinafter, referred to as a second high-frequency signal) of a horizontal polarization component (H) of high-frequency power. The power combination/distribution device 1 is provided in, for example, a phased array device that performs high-frequency communication (for example, 5G communication) using a quasi-millimeter wave band or the like.

The first power combination/distribution circuit 100 includes one input/output port 101 and two input/output ports 102. The two input/output ports 102 are connected to, for example, a front end of a phased array. In a case where first high-frequency signals of the same phase are input from the two input/output ports 102 (front end), the first power combination/distribution circuit 100 combines the first high-frequency signals and outputs the combined signal to one input/output port 101. In addition, in a case where the first high-frequency signal is input from one input/output port 101, the first power combination/distribution circuit 100 distributes (outputs) in phase the first high-frequency signal to the two input/output ports 102 (front ends).

The first power combination/distribution circuit 100 includes a plurality of first signal lines 110 for transmitting the first high-frequency signal. The two first signal lines 110 that connect the first power combination/distribution circuit 100 to the two input/output ports 102 are separated from each other toward the two input/output ports 102 from the first power combination/distribution circuit 100. A layout of the first signal lines 110 shown in FIG. 1 is an example, and the two first signal lines 110 may be laid out to be symmetrical or substantially symmetrical to the first power combination/distribution circuit 100, or may be laid out to be asymmetrical to the first power combination/distribution circuit 100.

The second power combination/distribution circuit 200 is laid out adjacent to the first power combination/distribution circuit 100. The second power combination/distribution circuit 200 includes one input/output port 201 and two input/output ports 202. The two input/output ports 202 are connected to, for example, a front end of a phased array different from the front end to which the first power combination/distribution circuit 100 is connected. In a case where second high-frequency signals of the same phase are input from the two input/output ports 202 (front ends), the second power combination/distribution circuit 200 combines the second high-frequency signals and outputs the combined signal to one input/output port 201. In addition, in a case where the second high-frequency signal is input from one input/output port 201, the second power combination/distribution circuit 200 distributes (outputs) in phase the second high-frequency signal to the two input/output ports 202 (front ends).

The second power combination/distribution circuit 200 includes a plurality of second signal lines 210 for transmitting the second high-frequency signal. The two second signal lines 210 that connect the second power combination/distribution circuit 200 to the two input/output ports 202 are separated from each other toward the two input/output ports 202 from the second power combination/distribution circuit 200. A layout of the second signal line 210 shown in FIG. 1 is an example, and the two second signal lines 210 may be laid out to be symmetrical or substantially symmetrical to the second power combination/distribution circuit 200, or may be laid out to be asymmetrical to the second power combination/distribution circuit 200.

The first signal line 110 extending from the first power combination/distribution circuit 100 to the second power combination/distribution circuit 200 side and the second signal line 210 extending from the second power combination/distribution circuit 200 to the first power combination/distribution circuit 100 side intersect each other in a plan view. That is, in a plan view, a portion where the first signal line 110 intersects the second signal line 210 is an intersection portion, and the power combination/distribution device 1 has an intersection portion 3. In addition, the power combination/distribution device 1 of the present embodiment has parallel running portions 4 in the vicinity of the intersection portion 3, each of which includes the first signal line 110 and the second signal line 210 running parallel with each other. In the schematic view shown in FIG. 1, the parallel running portions 4 are present on the right side and the left side of the intersection portion 3 on a paper surface. A form in which the parallel running portions 4 are not present in the vicinity of the intersection portion 3 may be adopted.

A wiring structure 2 for a high-frequency signal to be described below has a compact structure that implements high isolation (for example, 50 dB or more) in the intersection portion 3 of the first signal line 110 and the second signal line 210, and in the parallel running portion 4. Thereby, even when the first signal line 110 and the second signal line 210 are close to each other, crosstalk can be suppressed.

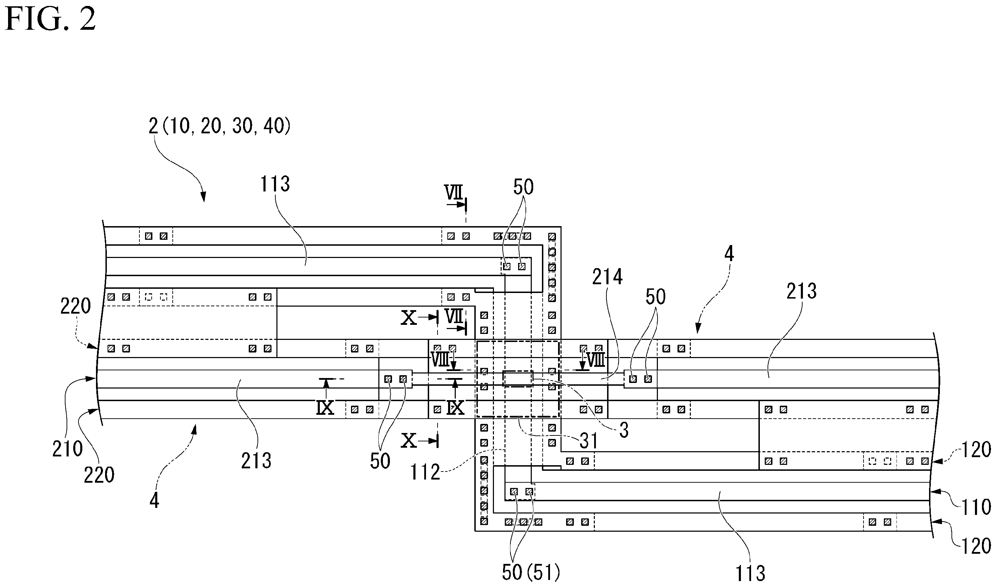

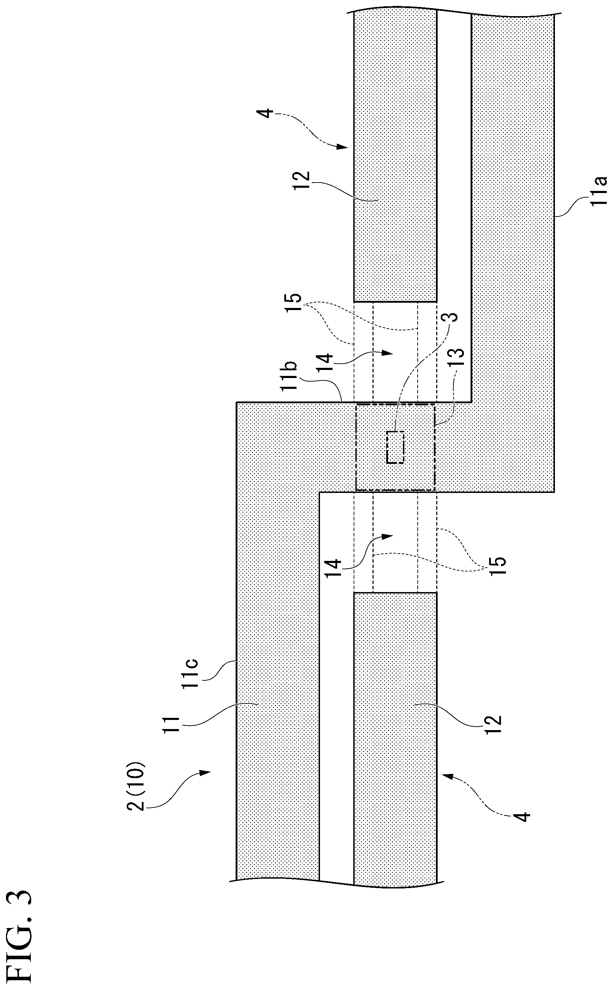

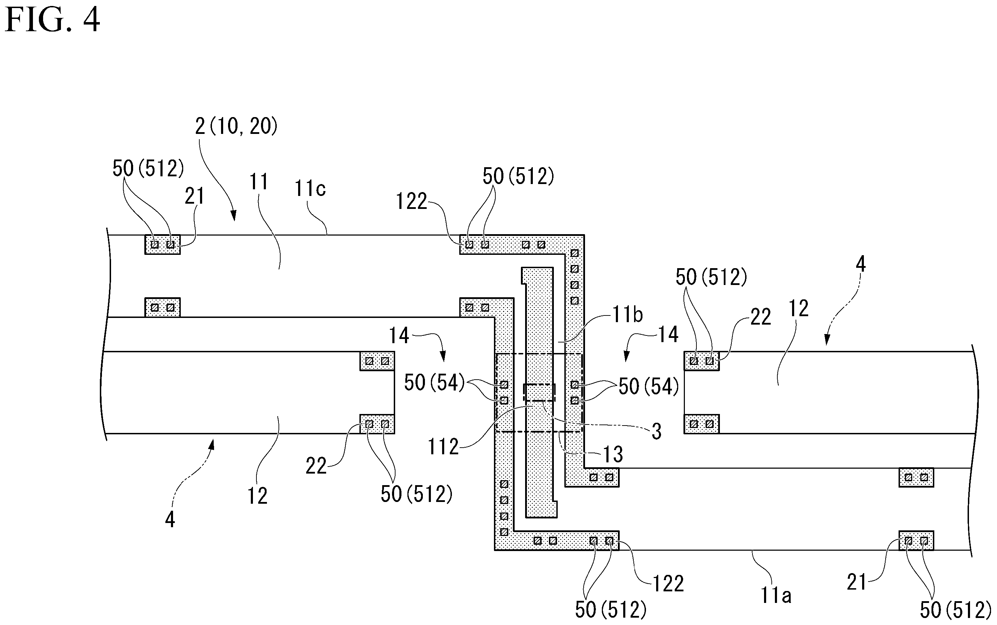

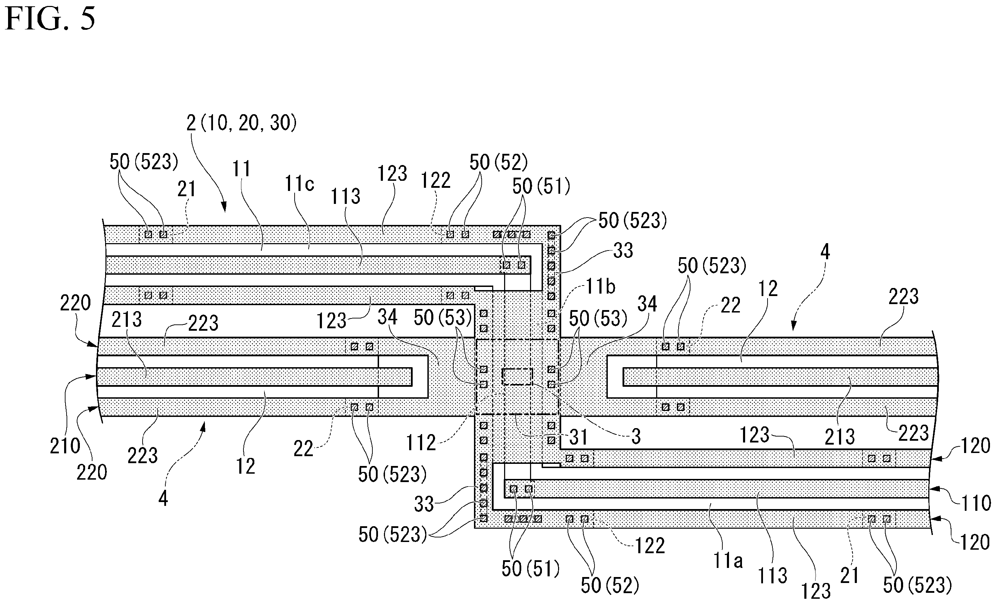

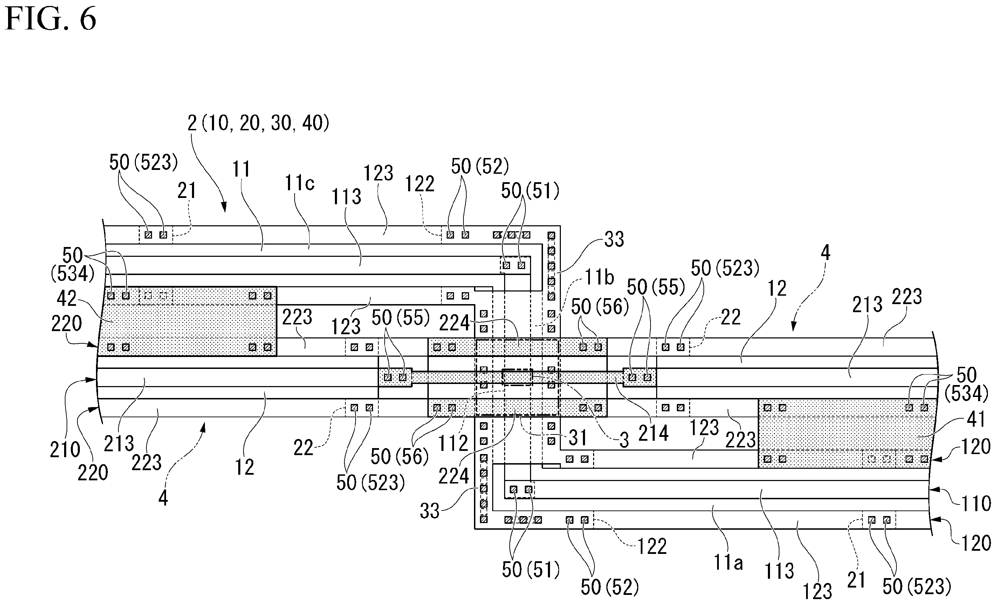

FIG. 2 is a plan view of the wiring structure 2 for a high-frequency signal according to the first embodiment. FIG. 3 is a plan view showing a first layer 10 of the wiring structure 2 for a high-frequency signal according to the first embodiment. FIG. 4 is a plan view showing a second layer 20 of the wiring structure 2 for a high-frequency signal according to the first embodiment. FIG. 5 is a plan view showing a third layer 30 of the wiring structure 2 for a high-frequency signal according to the first embodiment. FIG. 6 is a plan view showing a fourth layer 40 of the wiring structure 2 for a high-frequency signal according to the first embodiment.

As shown in FIGS. 2 to 6, the wiring structure 2 for a high-frequency signal of the present embodiment includes four conductor layers (the first layer 10, the second layer 20, the third layer 30, and the fourth layer 40). In FIGS. 3 to 6, a dot pattern serving as a mark is added to each conductor layer shown in each drawing to improve visibility.

The plan views mean, for example, viewing the wiring structure 2 for a high-frequency signal from a direction perpendicular to a paper surface in FIGS. 2 to 6. The first layer 10, the second layer 20, the third layer 30, and the fourth layer 40 are disposed in this order from a lower side to an upper side in a plan view direction. For the sake of convenience of description, in the plan view direction, the first layer 10 side is referred to as a lower side, and the fourth layer 40 side is referred to as an upper side, but the plan view direction may not coincide with a gravity direction. That is, the first layer 10 side may not be the lowermost layer in the gravity direction.

As shown in FIG. 2, the first signal line 110 is laid out in a crank shape in a plan view. The first signal line 110 is a strip-shaped conductor. A pair of first outside lines 120 are provided on both sides of the first signal line 110. The pair of first outside lines 120 are separated from the first signal line **110** at an equal distance and extend in parallel with the first signal line 110. The pair of first outside lines 120 are also strip-shaped conductors. The pair of first outside lines 120 are electrically grounded. The first signal line 110 and the pair of first outside lines 120 form a coplanar line. In addition, as shown in FIG. 3, since the first layer 10 (ground layer) that is electrically grounded is disposed on lower sides of the first signal line 110 and the pair of first outside lines 120, the first signal line 110, the pair of first outside lines 120, and the first layer 10 form a coplanar line with a ground.

The second signal line 210 extends linearly in a plan view, intersects a bent part of the first signal line **110** (crank) in a crossing manner, and runs parallel to a parallel part of the first signal line 110 (crank). The second signal line 210 is a strip-shaped conductor. A pair of second outside lines 220 are provided on both sides of the second signal line 210. The pair of second outside lines 220 are separated from the second signal lines 210 at an equal distance and extend in parallel with the second signal lines 210. The pair of second outside lines 220 are also strip-shaped conductors. The pair of second outside lines 220 are electrically grounded. The second signal line 210 and the pair of second outside lines 220 form a coplanar line.

The first signal line 110 and the pair of first outside lines 120 intersect the second signal line 210 and the pair of second outside lines 220 in a three-dimensional manner in the intersection portion 3. Specifically, the first signal line 110 and the pair of first outside lines 120 pass through a lower side of the intersection portion 3 and pass through the intersection portion 3 due to the multilayer structure in which the third layer 30 and the second layer 20 are connected to each other by the connection vias 50. In addition, the second signal line 210 and the pair of second outside lines 220 pass through the upper side of the intersection portion 3 and pass through the intersection portion 3 due to a multilayer structure in which the third layer 30 and the fourth layer 40 are connected to each other by the connection vias 50.

Hereinafter, the specific wiring structure 2 for a high-frequency signal will be described in order from the first layer 10 to the fourth layer 40.

As shown in FIG. 3, a first base portion 11 disposed on a lower side of the first signal line 110 and a pair of second base portions 12 disposed on a lower side of the second signal line 210 are provided on the first layer 10 (lowermost layer). The first base portion 11 has a crank shape in a plan view. The first base portion 11 is a strip-shaped conductor having a constant width and a constant thickness. The first base portion 11 includes the first signal line 110 and the pair of first outside lines 120 in a plan view.

The first base portion 11 includes a first linear portion 11a, a bent portion 11b, and a second linear portion 11c. The first linear portion 11a and the second linear portion 11c extend in parallel in a plan view and run parallel to the pair of second base portions 12. The bent portion 11b extends in a direction orthogonal to the first linear portion 11a and the second linear portion 11c in a plan view, and connects end portions of the first linear portion 11a and the second linear portion 11c, which are close to each other.

The pair of second base portions 12 are strip-shaped conductors, each having a constant width and a constant thickness. The pair of second base portions 12 include the second signal line 210 and the pair of second outside lines 220 in a plan view. The pair of second base portions 12 extend linearly in a plan view and are disposed to face each other with the bent portion 11b interposed therebetween. That is, a space portion 14 is present between the pair of second base portions 12 and the bent portion 11b. The pair of second base portions 12 and the bent portion 11b may be connected to each other through the strip-shaped conductor 15 as indicated by a dotted line in FIG. 3.

The first layer 10 is a ground layer and is electrically grounded. By setting the first layer 10 as a ground layer, electromagnetic fields of the first signal line 110 and the second signal line 210 can be stabilized. A second ground portion 13 including the intersection portion 3 in a plan view is provided on the bent portion 11b. Thereby, the electromagnetic field of the first signal line 110 that is close to the intersection portion 3 can be stabilized.

In FIGS. 2 to 6, the intersection portion 3 indicates only a part where the first signal line 110 intersects the second signal line 210 in a plan view. In a broad sense, the intersection portion 3 includes a part where the first signal line 110 and the pair of first outside lines 120 intersect the second signal line 210 and the pair of second outside lines 220 in a plan view. That is, the intersection portion 3 may include at least a part where the first signal line 110 intersects the second signal line 210 in a plan view, and may preferably include a part where the first signal line 110 and the pair of first outside lines 120 intersect the second signal line 210 and the pair of second outside lines 220. The second ground portion 13 described above and a first ground portion 31 described below are shown to be the same as a part where the first signal line 110 and the pair of first outside lines 120 intersect the second signal line 210 and the pair of second outside lines 220 in a plan view but may include the part in a plan view.

As shown in FIG. 4, the second layer 20 is disposed on an upper side of the first layer 10. A cross-under structure of the first signal line 110 and the pair of first outside lines 120 are provided on the second layer 20. Specifically, the second layer 20 is provided with a second layer first signal line 112 that forms the first signal line 110 in the second layer 20, and a pair of second layer first outside lines 122 that form a pair of first outside lines 120 in the second layer 20.

The second layer first signal line 112 is a strip-shaped conductor. The second layer first signal line 112 is disposed on an upper side of the bent portion 11b of the first base portion 11 of the first layer 10 and is included in the bent portion 11b in a plan view. A width of the second layer first signal line 112 in a lateral direction is less than a width of the first base portion 11 in the lateral direction. The second layer first signal line 112 extends along a central portion of the first base portion 11 in the lateral direction. In the present specification, the term "lateral direction" refers to a "width direction" in a line (strip-shaped conductor), and is used in a meaning different from a "longitudinal direction (long-side direction)" in the line (strip-shaped conductor).

The pair of second layer first outside lines 122 are also strip-shaped conductors. The pair of second layer first outside lines 122 are disposed in a crank shape on upper sides of an end portion of the first linear portion 11a of the first base portion 11 of the first layer 10 on the bent portion 11b side, the bent portion 11b, and an end portion of the second linear portion 11c on the bent portion 11b side, and are included in the first base portion 11 in a plan view. A width of each of the pair of second layer first outside lines 122 in the lateral direction is less than a width of the first base portion 11 in the lateral direction. The pair of second layer first outside lines 122 extend along both side edge portions of the first base portion 11 in the lateral direction in a plan view.

The pair of second layer first outside lines 122 are electrically connected to the first layer 10 (ground layer) through a plurality of connection vias 50. The plurality of connection vias 50 that connect the first layer 10 to the second layer 20 are referred to as first/second interlayer connection vias 512, and vias which electrically connect the pair of second layer first outside lines 122 to the second ground portion 13 are referred to particularly as fourth connection vias 54.

A plurality of second layer first pad portions 21 disposed on an upper side of the first base portion 11 and a plurality of second layer second pad portions 22 disposed on an upper side of the pair of second base portions 12, in addition to the second layer first signal line 112 and the pair of second layer first outside lines 122 are provided on the second layer 20. The second layer first pad portion 21 has a rectangular shape in a plan view and is disposed on both sides in a lateral direction at any position in a longitudinal direction of the first linear portion 11a and the second linear portion 11c of the first base portion 11.

The second layer second pad portion 22 has a rectangular shape in a plan view and is disposed on both sides in a lateral direction of end portions of the pair of second base portions 12 on the bent portion 11b side. Each of the plurality of second layer first pad portions 21 and the plurality of second layer second pad portions 22 is connected to the first layer 10 through the first/second interlayer connection vias 512. Each of the second layer first pad portion 21 and the second layer second pad portion 22 may have a rail shape in a plan view and may be connected to the first layer 10 through a plurality of first/second interlayer connection vias 512.

As shown in FIG. 5, the third layer 30 is disposed on an upper side of the second layer 20. The third layer 30 is provided with not only a structure of the intersection portion 3 of the first signal line 110 and the pair of first outside lines 120 but also a structure around the intersection portion 3. Specifically, a set of third layer first signal lines 113 that forms the first signal line 110 in the third layer 30, and a set of third layer first outside lines 123 that forms the pair of first outside lines 120 in the third layer 30 are provided on the third layer 30.

The third layer first signal line 113 is a strip-shaped conductor. The set of third layer first signal lines 113 is disposed on upper sides of the first linear portion 11a and the second linear portion 11c of the first base portion 11 of the first layer 10 and are included in the first linear portion 11a and the second linear portion 11c in a plan view. Widths of the set of third layer first signal lines 113 in a lateral direction are less than a width of the first base portion 11 in the lateral direction. The third layer first signal lines 113 extend along a central portion of the first base portion 11 in the lateral direction. End portions of the set of third layer first signal lines 113 on the intersection portion 3 side are disposed on an upper side of both end portions of the second layer first signal line 112.

Each of the end portions of the set of third layer first signal lines 113 on the intersection portion 3 side is connected to each of both end portions of the second layer first signal line 112 through a plurality of connection vias 50. Each of the end portions of the third layer first signal lines 113 on the intersection portion 3 side may be connected to each of both end portions of the second layer first signal line 112 connected to the end portions, through a single connection via 50. The plurality of connection vias 50 connecting between the second layer 20 and the third layer 30 are referred to as second/third interlayer connection vias 523, and among the vias, vias that electrically connect each of the end portions of the set of third layer first signal lines 113 on the intersection portion 3 side to each of both end portions of the second layer first signal line 112, are referred to particularly as first connection vias 51. A first high-frequency signal of the third layer first signal line 113 is transmitted to the second layer first signal line 112 (cross-under structure) through the first connection vias 51, and a line is changed at a right angle at the same time as a layer changes. Accordingly, the first high-frequency signal passes through the intersection portion 3.

The third layer first outside lines 123 are also strip-shaped conductors. A pair of third layer first outside lines 123 are provided on both sides of the third layer first signal line 113. The pair of third layer first outside lines 123 are separated from the third layer first signal line 113 at an equal distance and extend in parallel with the third layer first signal line 113. The set of third layer first outside lines 123 is linearly disposed on upper sides of the first linear portion 11a and the second linear portion 11c of the first base portion 11 of the first layer 10 and is included in the first linear portion 11a and the second linear portion 11c. The set of third layer first outside lines 123 extends along both side edge portions of the first base portion 11 in a lateral direction in a plan view.

Each of the end portions of the set of third layer first outside lines 123 on the intersection portion 3 side is connected to each of both end portions of the second layer first outside line 122 through a plurality of connection vias 50 (second/third interlayer connection vias 523). Among the second/third interlayer connection vias 523, vias that electrically connect each of the end portions of the set of third layer first outside lines 123 on the intersection portion 3 side to each of both end portions of the second layer first outside line 122, are particularly referred to as second connection vias 52.

In addition, the set of third layer first outside lines 123 is connected to the second layer 20 by a plurality of second/third interlayer connection vias 523 other than the second connection via 52. Specifically, each of the set of third layer first outside lines 123 is connected to the second layer first pad portion 21 by the second/third interlayer connection via 523. That is, the set of third layer first outside lines 123 is electrically connected to the first layer 10 (ground layer) through the second/third interlayer connection vias 523, the second layer first pad portion 21, and the first/second interlayer connection vias 512.

In addition, the third layer 30 is provided with not only a structure of the intersection portion 3 of the second signal line 210 and the pair of second outside lines 220 but also a structure around the intersection portion 3. Specifically, a set of third layer second signal lines 213 that forms the second signal line 210 in the third layer 30, and a set of third layer second outside lines 223 that forms the pair of second outside lines 220 in the third layer 30 is provided on the third layer 30.

The third layer second signal line 213 is a strip-shaped conductor. The set of third layer second signal lines 213 is disposed on upper sides of the pair of second base portions 12 of the first layer 10 and is included in the second base portions 12 in a plan view. A width of the third layer second signal line 213 in the lateral direction is less than a width of the second base portion 12 in the lateral direction. The third layer second signal line 213 extends along a central portion of the second base portion 12 in the lateral direction. End portions of the set of third layer second signal lines 213 on the intersection portion 3 side are disposed to face each other with the intersection portion 3 interposed therebetween in a plan view.

The third layer second outside lines 223 are also strip-shaped conductors. A pair of third layer second outside lines 223 are provided on both sides of the third layer second signal line 213. The pair of third layer second outside lines 223 are separated from the third layer second signal line 213 at an equal distance and extend in parallel with the third layer second signal line 213. The set of third layer second outside lines 223 is disposed on the upper side of the pair of second base portions 12 of the first layer 10 and is included in the second base portions 12 in a plan view. The set of third layer second outside lines 223 extends along both side edge portions of the pair of second base portions 12 in the lateral direction.

End portions of the set of third layer second outside lines 223 on the intersection portion 3 side are connected to the second layer second pad portions 22 through a plurality of second/third interlayer connection vias 523. That is, each of the set of third layer second outside lines 223 is electrically connected to the first layer 10 (ground layer) through the second/third interlayer connection vias 523, the second layer second pad portions 22, and the first/second interlayer connection vias 512.

In addition, a first ground portion 31 disposed in the intersection portion 3, and a third ground portion 33 and a fourth ground portion 34 disposed around the intersection portion 3 are provided on the third layer 30. The first ground portion 31, the third ground portion 33, and the fourth ground portion 34 are formed integrally. The first ground portion 31 has a rectangular shape in a plan view. The first ground portion 31 includes the intersection portion 3 in a plan view and is disposed between (between layers) the first signal line 110 (second layer first signal line 112) and the second signal line 210 (fourth layer second signal line 214) in a plan view direction. The first ground portion 31 of the present embodiment is further disposed between (between layers) a pair of first outside lines 120 (second layer first outside lines 122) and a pair of second outside lines 220 (fourth layer second outside lines 224) in the plan view direction.

The first ground portion 31 is connected to the second layer 20 by a plurality of connection vias 50 (second/third interlayer connection vias 523). Among the second/third interlayer connection vias 523, vias that electrically connect the first ground portion 31 to the pair of second layer first outside lines 122 are referred to particularly as third connection vias 53. The first ground portion 31 is electrically connected to the first layer 10 (ground layer) through the third connection vias 53, a pair of second layer first outside lines 122, and the fourth connection vias 54.

The third ground portion 33 is formed in a C-shape (or substantially a U-shape in a plan view) in a plan view. A pair of third ground portions 33 are provided and surround end portions of the set of third layer first signal lines 113 on the intersection portion 3 side in a plan view. Each of both end portions of the pair of third ground portions 33 having a C-shape in a plan view is connected to each of the end portions of the pair of third layer first outside lines 123 on the intersection portion 3 side. In addition, a side portion of the third ground portion 33 on the intersection portion 3 side is connected to the first ground portion 31.

The third ground portion 33 is connected to the second layer 20 by the plurality of connection vias 50 (second/third interlayer connection vias 523). Specifically, the third ground portion 33 is electrically connected to the first layer 10 (ground layer) through the second/third interlayer connection vias 523, the pair of second layer first outside lines 122, and the first/second interlayer connection vias 512.

The fourth ground portion 34 is formed in a C-shape (or substantially a U-shape in a plan view) in a plan view. A pair of fourth ground portions 34 are provided and surround end portions of each of the set of third layer second signal lines 213 in a plan view. Both end portions of the fourth ground portion 34 having a C-shape in a plan view are connected to end portions of the pair of third layer second outside lines 223 on the intersection portion 3 side. In addition, a side portion of the fourth ground portion 34 on the intersection portion 3 side is connected to the first ground portion 31.

The fourth ground portion 34 is connected to the second layer 20 by the plurality of connection vias 50 (second/third interlayer connection vias 523). Specifically, the fourth ground portion 34 is electrically connected to the first layer 10 (ground layer) through the second/third interlayer connection vias 523, the second layer second pad portions 22, and the first/second interlayer connection vias 512.

In the third layer 30, the third ground portion 33 and the fourth ground portion 34 are provided integrally around the first ground portion 31 including the intersection portion 3 in a plan view. That is, in the third layer 30, ground portions (the first ground portion 31, the third ground portion 33, and the fourth ground portion 34) having a cross shape in a plan view are provided in a part that overlaps the intersection portion 3 in the plan view.

The fourth layer 40 is disposed on an upper side of the third layer 30 as shown in FIG. 6. A crossover structure of the second signal line 210 and the pair of second outside lines 220 are provided on the fourth layer 40. Specifically, the fourth layer second signal line 214 that forms the second signal line 210 in the fourth layer 40, and a pair of fourth layer second outside lines 224 that form the pair of second outside lines 220 in the fourth layer 40 are provided on the fourth layer 40.

The fourth layer second signal line 214 is a strip-shaped conductor. The fourth layer second signal line 214 is disposed on an upper side of the first ground portion 31, overlaps the first ground portion 31 in a plan view, and extends linearly. In addition, both end portions of the fourth layer second signal line 214 are disposed on an upper side of each of the end portions of the set of third layer second signal lines 213 on the intersection portion 3 side. A width of a part in a lateral direction, other than both end portions of the fourth layer second signal line 214, is less than widths of the third layer second signal line 213 in the lateral direction, but this is a manufacturing reason for forming the fourth layer second outside lines 224 on both sides of the fourth layer second signal line 214, and a width of the fourth layer second signal line 214 in the lateral direction may be equal to a width of the third layer second signal line 213 in the lateral direction.

Each of both end portions of the fourth layer second signal line 214 is connected to each of the end portions of the set of third layer second signal lines 213 on the intersection portion 3 side through the plurality of connection vias 50. The end portion of the fourth layer second signal line 214 on the intersection portion 3 side may be connected to the end portion of the third layer second signal line 213 side connected to the end portion, through a single connection via 50. The plurality of connection vias 50 connecting the third layer 30 to the fourth layer 40 are referred to as third/fourth interlayer connection vias 534, and among the third/fourth interlayer connection vias 534, vias that electrically connect each of both end portions of the fourth layer second signal line 214 to each of the end portions of the set of third layer second signal lines 213 on the intersection portion 3 side, are referred to particularly as fifth connection vias 55. A second high-frequency signal of the third layer second signal line 213 is transmitted to the fourth layer second signal line 214 (crossover structure) through the fifth connection vias 55, and passes through the intersection portion 3.

The fourth layer second outside lines 224 are strip-shaped conductors. A pair of fourth layer second outside lines 224 are provided on both sides of the fourth layer second signal line 214. The pair of fourth layer second outside lines 224 are separated from the fourth layer second signal line 214 at an equal distance and extend in parallel with the fourth layer second signal line 214. Each of both end portions of the pair of fourth layer second outside lines 224 is disposed on an upper side of each of the end portions of the set of third layer second outside lines 223 on the intersection portion 3 side. Lengths of the pair of fourth layer second outside lines 224 are less than a length of the fourth layer second signal line 214, but this is a manufacturing reason for forming the fifth connection vias 55, and the lengths of the pair of fourth layer second outside lines 224 may be equal to the length of the fourth layer second signal line 214.

Each of both end portions of the pair of fourth layer second outside lines 224 is connected to each of the end portions of the set of third layer second outside lines 223 on the intersection portion 3 side through the plurality of connection vias 50 (third/fourth interlayer connection vias 534). Among the third/fourth interlayer connection vias 534, vias that electrically connect each of the both end portions of the pair of fourth layer second outside lines 224 to each of the end portions of the set of third layer second outside lines 223 on the intersection portion 3 side, are referred to particularly as sixth connection vias 56.

A first part 41 disposed on one side with the intersection portion 3 interposed therebetween in a plan view, and a second part 42 disposed on the other side with the intersection portion 3 interposed therebetween in a plan view, in addition to the fourth layer second signal line 214 and the pair of fourth layer second outside lines 224 are provided on the fourth layer. Each of the first part 41 and the second part 42 has a rectangular shape in a plan view, and is disposed to extend over between one side of the pair of third layer first outside lines 123 and one side of the pair of third layer second outside lines 223, which are close to and run parallel with each other in the third layer 30.

The first part 41 and the second part 42 are electrically connected to one side of the pair of third layer first outside lines 123 and one side of the pair of third layer second outside lines 223, which are close to and run parallel with each other in the third layer 30, through the plurality of third/fourth interlayer connection vias 534. That is, the first part 41 and the second part 42 are connected to the first layer (ground layer) through the third/fourth interlayer connection vias 534, the third layer first outside lines 123, the third layer second outside lines 223, the second/third interlayer connection vias 523, the second layer first pad portions 21, and the first/second interlayer connection vias 512.

Next, a characteristic cross-sectional configuration of the wiring structure 2 of the above-described high-frequency signal will be described.

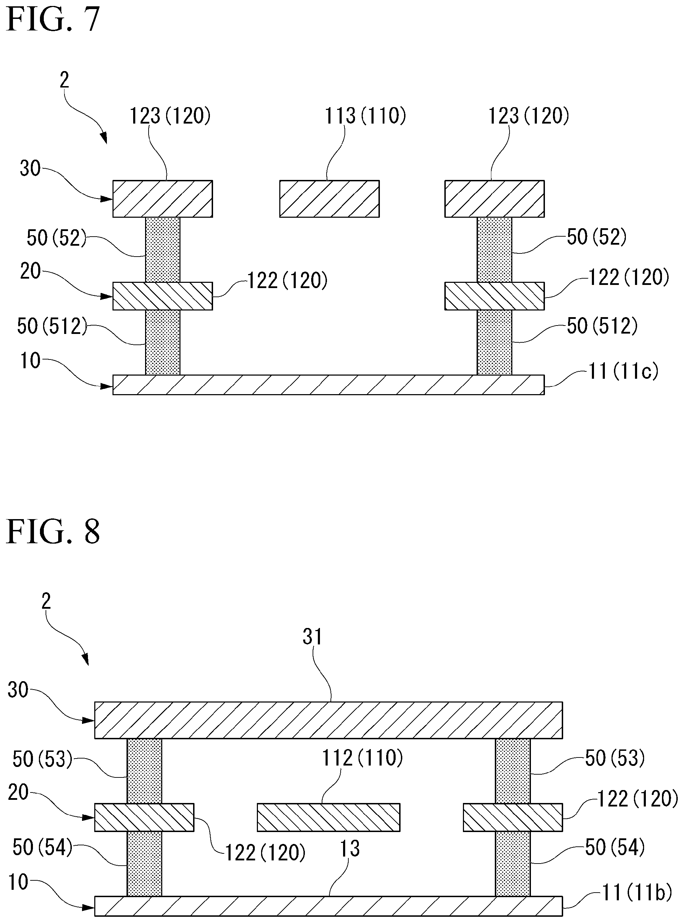

FIG. 7 is a cross-sectional view taken along line VII-VII shown in FIG. 2.

As shown in FIG. 7, the third layer first signal line 113 is provided on the third layer 30. The pair of third layer first outside lines 123, the pair of second connection vias 52 (second/third interlayer connection vias 523), the pair of second layer first outside lines 122, the pair of first/second interlayer connection vias 512, and the first base portion 11 (first layer 10) are disposed around the third layer first signal line 113. That is, the third layer first signal line 113 is surrounded substantially in a U shape by the pair of third layer first outside lines 123, the pair of second connection vias 52 (second/third interlayer connection vias 523), the pair of second layer first outside lines 122, the pair of first/second interlayer connection vias 512, and the first base portion 11 (first layer 10). Therefore, an electromagnetic field in the third layer first signal line 113 is stabilized. The pair of second layer first outside lines 122 function as pads in the same manner as the second layer first pad portions 21 and the second layer second pad portions 22.

FIG. 8 is a cross-sectional view taken along line VIII-VIII shown in FIG. 2.

As shown in FIG. 8, the second layer first signal line 112 (cross-under structure) is provided on the second layer 20. A pair of second layer first outside lines 122, the pair of third connection vias 53 (second/third interlayer connection vias 523), the first ground portion 31 (third layer 30), the pair of fourth connection vias 54 (first/second interlayer connection vias 512), and the second ground portion 13 (first layer 10) are disposed around the second layer first signal line 112. That is, the second layer first signal line 112 is surrounded at the top and bottom and on the left and right by the pair of third connection vias 53 (second/third interlayer connection vias 523), the first ground portion 31 (third layer 30), the pair of second layer first outside lines 122, the pair of fourth connection vias 54 (first/second interlayer connection vias 512), and the second ground portion 13 (first layer 10). Therefore, an electromagnetic field in the second layer first signal line 112 is stabilized.

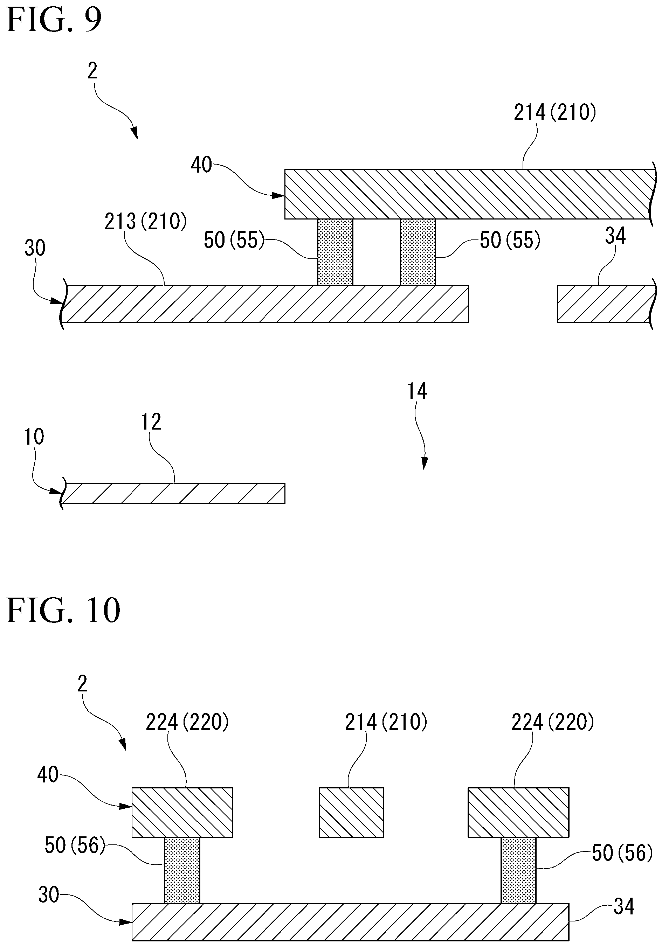

FIG. 9 is a cross-sectional view taken along line IX-IX shown in FIG. 2.

As shown in FIG. 9, the third layer second signal line 213 is provided on the third layer 30. A gap is formed between an end portion of the third layer second signal line 213 on the intersection portion 3 side and the fourth ground portion 34. The end portion of the third layer second signal line 213 on the intersection portion 3 side is connected to one end portion of the fourth layer second signal line 214 through the fifth connection vias 55. Therefore, the second high-frequency signal of the third layer second signal line 213 is transmitted to the fourth layer second signal line 214 (crossover structure) and passes through an upper side of the fourth ground portion 34. A space portion 14 (see FIG. 3) is present on one end portion of the fourth layer second signal line 214 and lower sides of the fifth connection vias 55. Thereby, the second high-frequency signal smoothly flows from the third layer second signal line 213 to the fourth layer second signal line 214.

FIG. 10 is a cross-sectional view taken along line X-X shown in FIG. 2.

As shown in FIG. 10, the fourth layer second signal line 214 is provided on the fourth layer 40. The pair of fourth layer second outside lines 224, the pair of sixth connection vias 56 (third/fourth interlayer connection vias 534), and the fourth ground portion 34 are disposed around the fourth layer second signal line 214. That is, the fourth layer second signal line 214 is surrounded substantially in a U shape by the pair of fourth layer second outside lines 224, the pair of sixth connection vias 56 (third/fourth interlayer connection vias 534), and the fourth ground portion 34. Therefore, an electromagnetic field in the fourth layer second signal line 214 is stabilized.

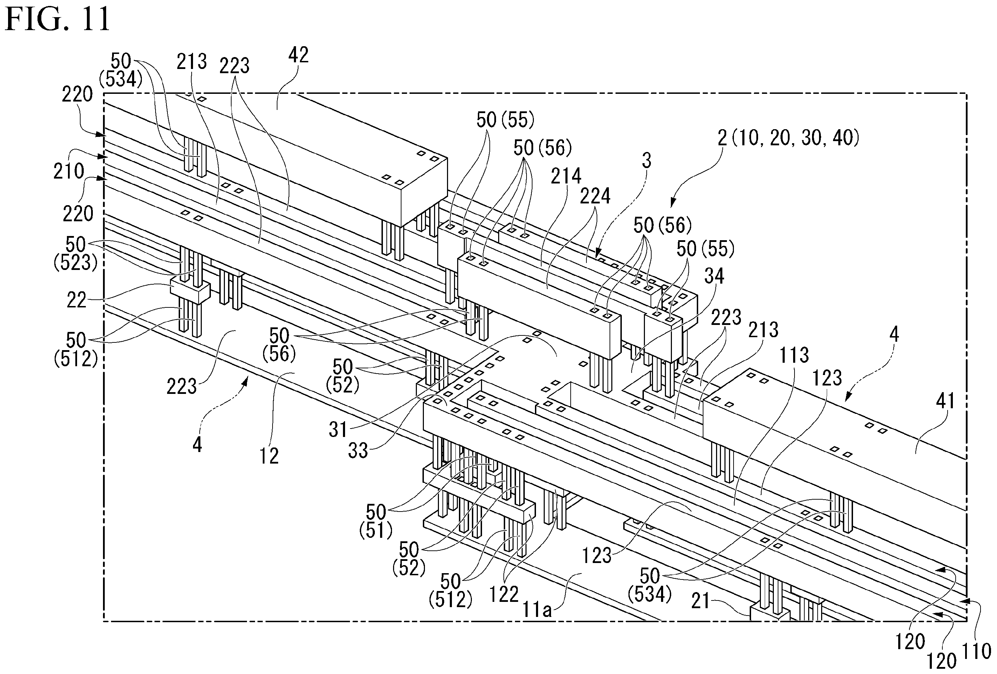

FIG. 11 is a perspective view of the wiring structure 2 for a high-frequency signal according to the first embodiment.

As shown in FIG. 11, the wiring structure 2 for a high-frequency signal has a three-dimensional configuration in which the first signal line 110 has a cross-under structure and the second signal line 210 has a crossover structure in the intersection portion 3. Then, the first signal line 110 and the second signal line 210 that transmit high-frequency signals different from each other are disposed in the intersection portion 3 with the first ground portion 31 including the intersection portion 3 interposed therebetween in a plan view direction. The first ground portion 31 serves as a shield in the intersection portion 3 of the first signal line 110 and the second signal line 210, and suppresses crosstalk between the first signal line 110 and the second signal line 210.

In this way, the wiring structure 2 for a high-frequency signal according to the present embodiment includes the first signal line 110 that transmits a first high-frequency signal, and the second signal line 210 which transmits a second high-frequency signal different from the first high-frequency signal and of which at least a part is formed on a layer different from a layer of the first signal line 110, and has the intersection portion 3 where the first signal line 110 and the second signal line 210 intersect each other in a plan view, and the first ground portion 31 including the intersection portion 3 in a plan view and disposed between the first signal line 110 and the second signal line 210 in a plan view direction is provided in the intersection portion 3. According to this configuration, crosstalk in the intersection portion 3 of two signal lines for transmitting high-frequency signals different from each other can be suppressed.

In addition, in the present embodiment, the first high-frequency signal is one of a signal of a vertical polarization component and a signal of a horizontal polarization component, and the second high-frequency signal is the other of the signal of the vertical polarization component and the signal of the horizontal polarization component. According to this configuration, crosstalk of a signal of a vertical polarization component and a signal of a horizontal polarization component can be suppressed.

In addition, in the present embodiment, conductor layers including four layers are provided, and the conductor layers include the first layer 10, the second layer 20, the third layer 30, and the fourth layer 40 which are stacked in this order, the first ground portion 31 is provided on the third layer 30, the first signal line 110 is provided on the second layer 20 in the intersection portion 3, the second signal line 210 is provided on the fourth layer 40 in the intersection portion 3, and the second ground portion 13 including the intersection portion 3 is provided on the first layer 10 in a plan view. According to this configuration, the wiring structure 2 for a high-frequency signal can be formed by four conductor layers, and electromagnetic fields of the first signal line 110 and the second signal line 210 can be stabilized by the first ground portion 31 formed in the third layer 30.

In addition, in the present embodiment, the first signal line 110 includes the second layer first signal line 112 provided on the second layer 20, a set of third layer first signal lines 113 provided on the third layer 30, and the first connection via 51 connecting each of both end portions of the second layer first signal line 112 to an end portion of each of the set of third layer first signal lines 113 on the intersection portion 3 side. According to this configuration, it is possible to form a cross-under structure of the first signal line 110 that passes through a lower side of the first ground portion 31 in the intersection portion 3.

In addition, in the present embodiment, the second layer first signal line 112 extends in a direction orthogonal to a direction in which the set of third layer first signal lines 113 extends in a plan view. According to this configuration, in the first signal line 110, not only a layer in the first connection via 51 changes, but also a line is changed at a right angle at the same time as the layer changes. Thereby, the first signal line 110 and the second signal line 210 can be intersected with each other in a space-saving manner. Since the second layer first signal line 112 is a line different from the other lines, a length of the second layer first signal line 112 can be as short as possible by the above-described configuration, and characteristics of a high-frequency signal can be prevented from being affected.

In addition, in the present embodiment, the third ground portion 33 that surrounds an end portion of each of the set of third layer first signal lines 113 on the intersection portion 3 side in a plan view is provided on the third layer 30. According to this configuration, an end portion of each of the set of third layer first signal lines 113 on the intersection portion 3 side is surrounded by the third ground portion 33 having a C shape, and an electromagnetic field in the vicinity thereof can be stabilized.

In addition, in the present embodiment, a pair of first outside lines 120 are provided on both sides of the first signal line 110, and the first outside lines 120 include a pair of second layer first outside lines 122 provided on both sides of the second layer first signal line 112 in the second layer 20, a set of third layer first outside lines 123 provided in pairs on both sides of each of the set of third layer first signal lines 113 in the third layer 30, and the second connection via 52 connecting each of both end portions of the second layer first outside line 122 to an end portion of each of the set of third layer first outside lines 123 on the intersection portion 3 side. According to this configuration, a coplanar line of a cross-under structure can be formed by the first signal line 110 and the pair of first outside lines 120.

In addition, in the present embodiment, the wiring structure for a high-frequency signal includes the third connection via 53 connecting the second layer first outside line 122 to the third layer 30, and the fourth connection via 54 connecting the second layer first outside line 122 to the first layer 10, in which at least a part of the second layer first signal line 112 is disposed in a space surrounded by the first layer 10, the third layer 30, the second layer first outside lines 122, the third connection vias 53, and the fourth connection vias 54. According to this configuration, as shown in FIG. 8, the second layer first signal line 112 (cross-under structure) is surrounded by the ground on the left and right, and at the top and bottom, thereby being less likely to be affected by electromagnetic influences from others or to affect the surroundings.

In addition, the power combination/distribution device 1 according to the present embodiment includes the wiring structure 2 for the high-frequency signal, and the first power combination/distribution circuit 100 (see FIG. 1) including the first signal line 110 intersecting the second signal line 210 and the first signal line 110 not intersecting the second signal line 210 by the wiring structure 2. According to this configuration, crosstalk between a first high-frequency signal handled by the first power combination/distribution circuit 100 and the second high-frequency signal in the intersection portion 3 can be suppressed.

In addition, in the present embodiment, the second signal line 210 includes the fourth layer second signal line 214 provided on the fourth layer 40, a set of third layer second signal lines 213 provided on the third layer 30, and the fifth connection vias 55 connecting each of both end portions of the fourth layer second signal line 214 to an end portion of each of the set of third layer second signal lines 213 on the intersection portion 3 side. According to this configuration, it is possible to form a crossover structure of the second signal line 210 that passes through an upper side of the first ground portion 31 in the intersection portion 3.

In addition, in the present embodiment, the fourth ground portion 34 that surrounds an end portion of each of the set of third layer second signal lines 213 on the intersection portion 3 side in a plan view is provided on the third layer 30. According to this configuration, an end portion of each of the set of third layer second signal lines 213 on the intersection portion 3 side is surrounded by the fourth ground portion 34 having a C shape, and an electromagnetic field in the vicinity thereof can be stabilized.

In addition, in the present embodiment, a pair of second outside lines 220 are provided on both sides of the second signal line 210, and the second outside lines 220 include a pair of fourth layer second outside lines 224 provided on both sides of the fourth layer second signal line 214 in the fourth layer 40, a set of third layer second outside lines 223 provided in pairs on both sides of each of the set of third layer second signal lines 213 in the third layer 30, and the sixth connection via 56 connecting each of both end portions of the fourth layer second outside line 224 to the end portion of each of the set of third layer second outside lines 223 on the intersection portion 3 side. According to this configuration, a coplanar line of a crossover structure can be formed by the second signal line 210 and the pair of second outside lines 220.

In addition, in the present embodiment, the fourth ground portion 34 that surrounds an end portion of each of the set of third layer second signal lines 213 on the intersection portion 3 side in a plan view is provided on the third layer 30. According to this configuration, an end portion of each of the set of third layer second signal lines 213 on the intersection portion 3 side is surrounded by the fourth ground portion 34 having a C shape, and an electromagnetic field in the vicinity thereof can be stabilized.

In addition, in the present embodiment, the sixth connection via 56 connects the fourth layer second outside lines 224 to the fourth ground portion 34, and the fourth ground portion 34, the fourth layer second outside lines 224, and the sixth connection via 56 are disposed around at least part of the fourth layer second signal line 214. According to this configuration, as shown in FIG. 10, the fourth layer second signal line 214 (crossover structure) is surrounded by the ground on the left and right and at the bottom except the top, and thus, an electromagnetic influence from others is less likely to be received. Since a length of the fourth layer second signal line 214 is less than a length of the second layer first signal line 112, it is difficult to exert an electromagnetic influence on the surroundings. In addition, since the fourth layer second signal line 214 is slightly longer than the first ground portion 31 and the second ground portion 13, it is difficult to exert an electromagnetic influence on the surroundings. In addition, since the fourth layer second signal line 214 is provided on a layer different from the third layer 30, it is difficult to exert an electromagnetic influence on the surroundings.

In addition, the power combination/distribution device 1 according to the present embodiment includes the wiring structure 2 for a high-frequency signal, and the second power combination/distribution circuit 200 including the second signal line 210 that intersects the first signal line 110 by the wiring structure, and the second signal line 210 that does not intersect the first signal line 110. According to this configuration, crosstalk between the second high-frequency signal handled by the second power combination/distribution circuit 200 and the first high-frequency signal in the intersection portion 3 can be suppressed.

In addition, in the present embodiment, the fourth layer 40 has the first part 41 disposed on one side of the intersection portion 3 interposed therebetween in a plan view and the second part 42 disposed on the other side of the intersection portion 3 interposed therebetween in a plan view. According to this configuration, even in a case where the parallel running portion 4 is present around the intersection portion 3, the ground between lines running parallel with the parallel running portion 4 is provided, and thus, an electromagnetic field from each line can be stabilized and coupling can be weakened. It is preferable that the first part 41 and the second part 42 are disposed around the intersection portion 3.

### (Second Embodiment)

Next, a second embodiment of the present invention will be described. In the following description, the same or equivalent configurations as in the above-described embodiment are denoted by the same reference numerals, and descriptions thereof are simplified or omitted.

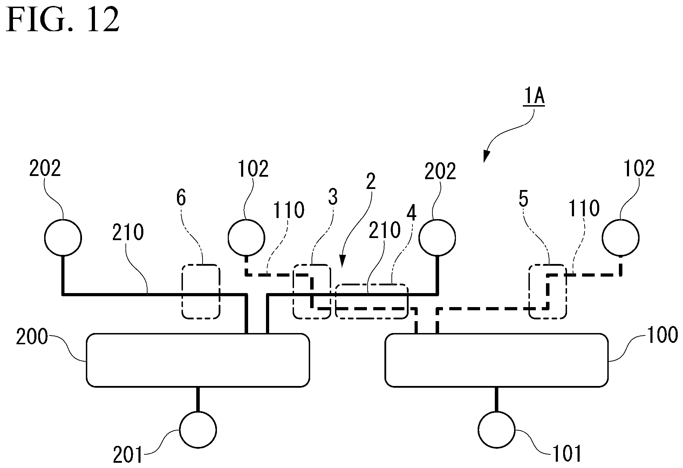

FIG. 12 is a schematic plan view of a power combination/distribution device 1A according to a second embodiment.

As shown in FIG. 12, a first power combination/distribution circuit 100 of the second embodiment is different from the above-described embodiment in that a cross-under structure 5 is also provided in a first signal line 110 that does not intersect a second signal line 210. In addition, a second power combination/distribution circuit 200 of the second embodiment is different from the above-described embodiment in that a crossover structure 6 is also provided in the second signal line 210 that does not intersect the first signal line 110.

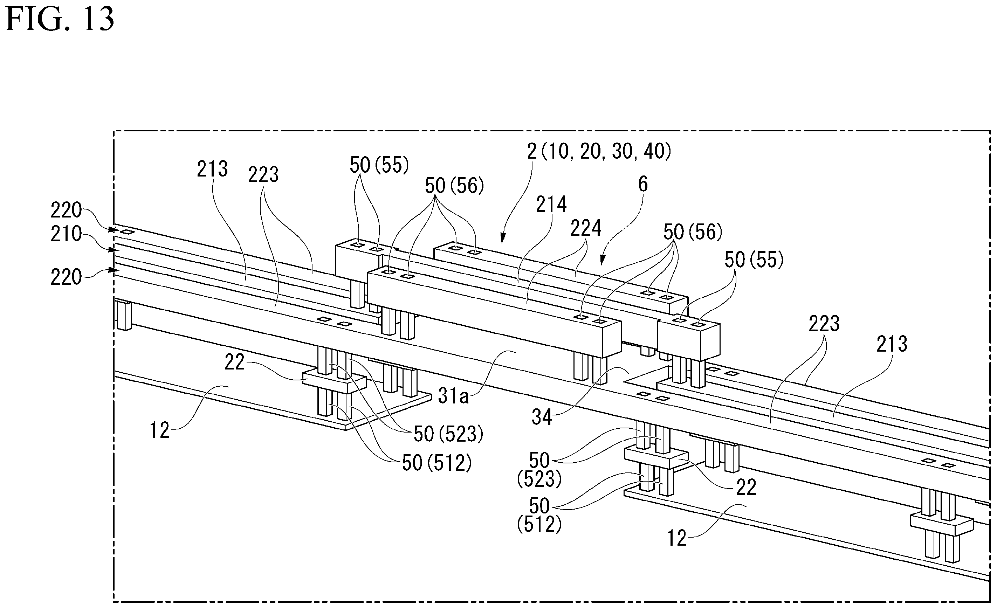

FIG. 13 is a perspective view showing the crossover structure 6 of the second signal line 210 according to the second embodiment.

As shown in FIG. 13, a fourth layer second signal line 214, a set of third layer second signal lines 213, and fifth connection vias 55 are also provided on the second signal line 210 that does not intersect the first signal line 110. In addition, fourth layer second outside lines 224, a set of third layer second outside lines 223, and sixth connection vias 56 are also provided in second outside lines 220 on both sides of the second signal line 210. According to this configuration, since a configuration of the second signal line 210 intersecting the first signal line 110 is the same as a configuration of the second signal line 210 not intersecting the first signal line 110, power combination/distribution characteristics according to an original design of combining and distributing the second high-frequency signals in the same phase can be obtained. The crossover structure 6 of the second signal line 210 that does not intersect the first signal line 110 may be at a position (at an equal distance with respect to the second power combination/distribution circuit 200) that is symmetrical to a crossover structure of the second signal line 210 intersecting the first signal line 110 with respect to the intersection portion 3, but may not be at the position that is symmetrical thereto.

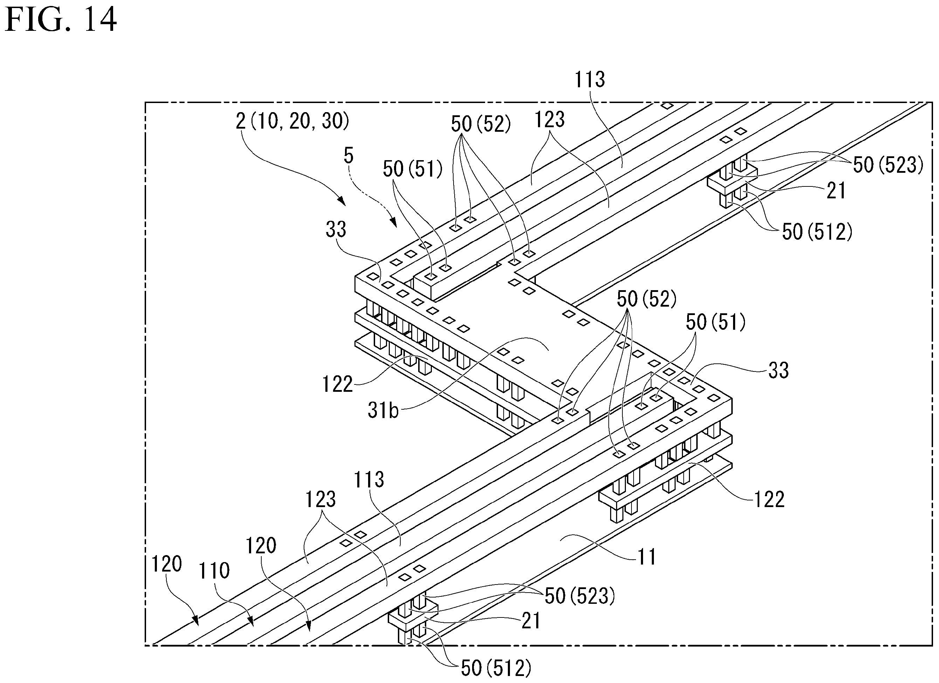

FIG. 14 is a perspective view showing the cross-under structure 5 of the first signal line 110 according to the second embodiment.

As shown in FIG. 14, a second layer first signal line 112 (not shown in FIG. 14), a set of third layer first signal lines 113, and first connection vias 51 are also provided in the first signal line 110 that does not intersect the second signal line 210. In addition, a second layer first outside line 122, a set of third layer first outside lines 123, and second connection vias 52 are also provided in first outside lines 120 on both sides of the first signal line 110. According to this configuration, since a configuration of the first signal line 110 intersecting the second signal line 210 is the same as a configuration of the first signal line 110 not intersecting the second signal line 210, power combination/distribution characteristics according to an original design of combining and distributing the first high-frequency signals in the same phase can be obtained. The cross-under structure 5 of the first signal line 110 that does not intersect the second signal line 210 may be at a position (equal distance with respect to the first power combination/distribution circuit 100) that is symmetrical to a cross-under structure of the first signal line 110 intersecting the second signal line 210 with respect to the intersection portion 3, but may not be at the position that is symmetrical thereto.

### (Third Embodiment)

Next, a third embodiment of the present invention will be described. In the following description, the same or equivalent configurations as in the above-described embodiment are denoted by the same reference numerals, and descriptions thereof are simplified or omitted.

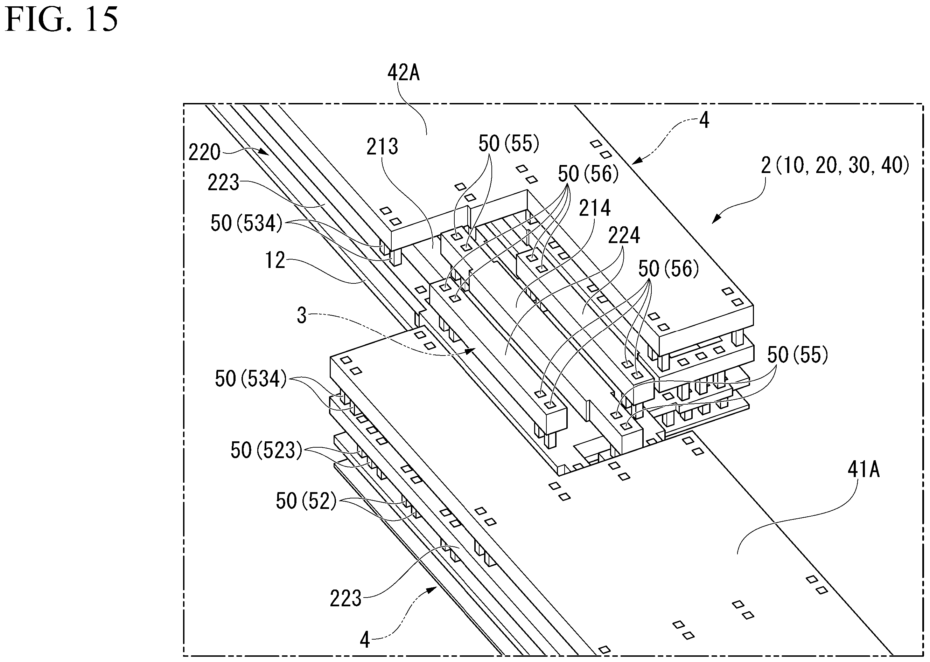

FIG. 15 is a perspective view of a wiring structure 2 for a high-frequency signal according to a third embodiment.

As shown in FIG. 15, a first part 41A and a second part 42A of a fourth layer 40 of the third embodiment have shapes that cover parts other than an intersection portion 3 in a plan view. That is, the first part 41A and the second part 42A cover the entire parallel running portion 4 of a third layer first signal line 113 and a third layer first outside line 123, and a third layer second signal line 213 and a third layer second outside line 223. According to this configuration, in a third layer 30, left, right, top, and bottom of each of the first signal line 110 and the second signal line 210 are surrounded by the ground, thereby being less likely to be affected by electromagnetic influences from others or to affect the surroundings.

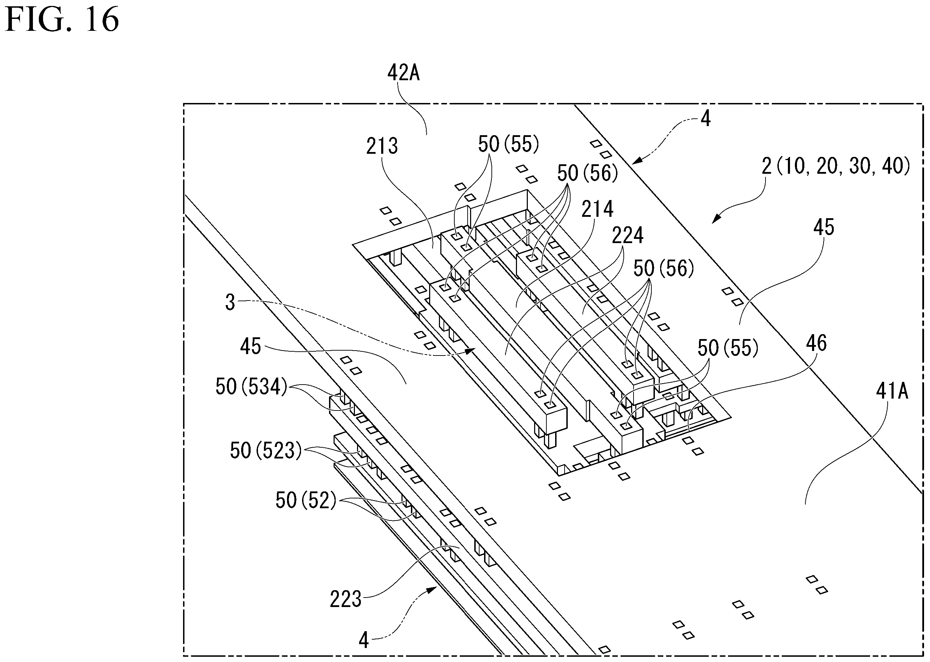

FIG. 16 is a perspective view of a wiring structure 2 for a high-frequency signal according to a modification example of the third embodiment. A fourth layer 40 shown in FIG. 16 may have a connection portion 45 that connects a first part 41A to a second part 42A at a position where the first part 41A and the second part 42A do not overlap the intersection portion 3 in a plan view. That is, the fourth layer 40 may have a shape, in which an opening portion 46 is formed, in a part corresponding to the intersection portion 3. Thereby, a part excluding the intersection portion 3 can be covered with the ground. The connection portion 45 may not only connect the first part 41A to the second part 42A but also appropriately include a connection via (seventh connection via) for being connected to a third layer 30 (a first outside line 120 and a second outside line 220).

As described above, while preferred embodiments of the present invention are described and illustrated, it should be understood that these are examples of the present invention and should not be considered as limiting. Additions, omissions, substitutions, and other modifications can be made without departing from the scope of the present invention. Accordingly, the present invention should not be considered as being limited by the above description, and is only limited by the scope of the appended claims.

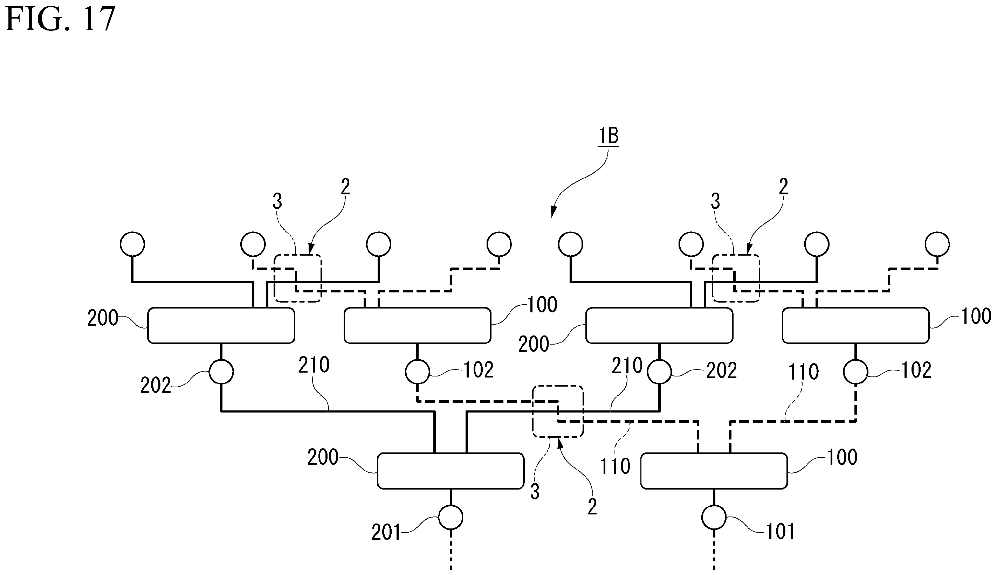

For example, as in one modification example shown in FIG. 17, a power combination/distribution device 1B may include a plurality of first power combination/distribution circuits 100 connected to each other and a plurality of second power combination/distribution circuits 200 connected to each other in a tournament method.

In addition, for example, the wiring structure 2 for a high-frequency signal may be applied to a high-frequency device other than a phased array device. That is, the wiring structure 2 for a high-frequency signal can be applied not only to lines between which a signal of a vertical polarization component and a signal of a horizontal polarization component are transmitted but also to lines between which high-frequency signals of frequency bands different from each other are transmitted.

In addition to this, within the scope not departing from the gist of the present invention, constituent elements in the embodiments described above can be appropriately replaced with well-known constituent elements, and the embodiments and modification examples described above may be appropriately combined with each other.

### INDUSTRIAL APPLICABILITY

According to an aspect of the present invention, it is possible to suppress crosstalk in an intersection portion of two signal lines that transmit high-frequency signals different from each other.

### REFERENCE SIGNS LIST

1 Power combination/distribution device
1A Power combination/distribution device
1B Power combination/distribution device
2 Wiring structure for high-frequency signal
3 Intersection portion
4 Parallel running portion
5 Cross-under structure
6 Crossover structure
10 First layer
11 First base portion
11a First linear portion
11b Bent portion
11c Second linear portion
12 Second base portion
13 Second ground portion
14 Space portion
15 Strip-shaped conductor
20 Second layer
21 Second layer first pad portion
22 Second layer second pad portion
30 Third layer
31 First ground portion
33 Third ground portion
34 Fourth ground portion
40 Fourth layer
41 First part
41A First part
42 Second part
42A Second part
45 Connection portion
46 Opening portion
50 Connection via
51 First connection via
52 Second connection via
53 Third connection via
54 Fourth connection via
55 Fifth connection via
56 Sixth connection via
100 First power combination/distribution circuit
101 Input/output port
102 Input/output port
110 First signal line
112 Second layer first signal line
113 Third layer first signal line
120 First outside line
122 Second layer first outside line
123 Third layer first outside line
200 Second power combination/distribution circuit
201 Input/output port
202 Input/output port
210 Second signal line
213 Third layer second signal line
214 Fourth layer second signal line
220 Second outside line
223 Third layer second outside line
224 Fourth layer second outside line
512 First/second interlayer connection via
523 Second/third interlayer connection via
534 Third/fourth interlayer connection via

## Claims

1. A wiring structure for a high-frequency signal, the wiring structure comprising:
a first signal line configured to transmit a first high-frequency signal; and
a second signal line configured to transmit a second high-frequency signal different from the first high-frequency signal,
wherein a part where the first signal line intersects the second signal line in a plan view is an intersection portion,
the first signal line and the second signal line are formed on different layers in the intersection portion, and
a first ground portion including the intersection portion in a plan view and disposed between the first signal line and the second signal line in a plan view direction is provided in the intersection portion.

2. The wiring structure for a high-frequency signal according to Claim 1,
wherein the first high-frequency signal is one of a signal of a vertical polarization component and a signal of a horizontal polarization component, and
the second high-frequency signal is the other of the signal of the vertical polarization component and the signal of the horizontal polarization component.

3. The wiring structure for a high-frequency signal according to Claim 1 or 2, further comprising:
conductor layers including four layers,
wherein the conductor layers include a first layer, a second layer, a third layer, and a fourth layer which are stacked in this order,
the first ground portion is provided on the third layer,
the first signal line is provided on the second layer in the intersection portion,
the second signal line is provided on the fourth layer in the intersection portion, and
a second ground portion including the intersection portion is provided on the first layer in a plan view.

4. The wiring structure for a high-frequency signal according to Claim 3,
wherein the first signal line includes:
a second layer first signal line provided on the second layer;
a set of third layer first signal lines provided on the third layer; and
a first connection via configured to connect each of both end portions of the second layer first signal line and an end portion of each of the set of third layer first signal lines on an intersection portion side.

5. The wiring structure for a high-frequency signal according to Claim 4,
wherein the second layer first signal line extends in a direction orthogonal to a direction in which the set of third layer first signal lines extends in a plan view.

6. The wiring structure for a high-frequency signal according to Claim 4 or 5,
wherein a third ground portion configured to surround the end portion of each of the set of third layer first signal lines on the intersection portion side in a plan view is provided on the third layer.

7. The wiring structure for a high-frequency signal according to any one of Claims 4 to 6,
wherein a pair of first outside lines are provided on both sides of the first signal line, and
the first outside lines include:
a pair of second layer first outside lines provided on both sides of the second layer first signal line on the second layer;
a set of third layer first outside lines provided in pairs on both sides of each of the set of third layer first signal lines on the third layer; and
a second connection via configured to connect each of both end portions of the second layer first outside lines and an end portion of each of the set of third layer first outside lines on the intersection portion side.

8. The wiring structure for a high-frequency signal according to Claim 7, further comprising:
a third connection via configured to connect the second layer first outside line and the third layer; and
a fourth connection via configured to connect the second layer first outside line and the first layer,
wherein at least part of the second layer first signal line is disposed in a space surrounded by the first layer, the third layer, the second layer first outside line, the third connection via, and the fourth connection via.

9. A power combination/distribution device comprising:
the wiring structure for a high-frequency signal according to any one of Claims 1 to 8; and
a first power combination/distribution circuit including the first signal line intersecting the second signal line and the first signal line not intersecting the second signal line by the wiring structure.

10. A power combination/distribution device comprising:
the wiring structure for a high-frequency signal according to any one of Claims 4 to 8; and
a first power combination/distribution circuit including the first signal line intersecting the second signal line and the first signal line not intersecting the second signal line by the wiring structure,
wherein the second layer first signal line, the set of third layer first signal lines, and the first connection via are provided also in the first signal line not intersecting the second signal line.

11. The wiring structure for a high-frequency signal according to any one of Claims 3 to 8,
wherein the second signal line includes:
a fourth layer second signal line provided on the fourth layer;
a set of third layer second signal lines provided on the third layer; and
fifth connection vias configured to connect each of both end portions of the fourth layer second signal line and an end portion of each of the set of third layer second signal lines on an intersection portion side.

12. The wiring structure for a high-frequency signal according to Claim 11,
wherein a fourth ground portion configured to surround the end portion of each of the set of third layer second signal lines on the intersection portion side in a plan view is provided on the third layer.

13. The wiring structure for a high-frequency signal according to Claim 11 or 12,
wherein a pair of second outside lines are provided on both sides of the second signal line, and
the second outside lines include:
a pair of fourth layer second outside lines provided on both sides of the fourth layer second signal line on the fourth layer;
a set of third layer second outside lines provided in pairs on both sides of each of the set of third layer second signal lines on the third layer; and
a sixth connection via configured to connect each of both end portions of the fourth layer second outside lines and the end portion of each of the set of third layer second outside lines on the intersection portion side.

14. The wiring structure for a high-frequency signal according to Claim 13,
wherein a fourth ground portion configured to surround the end portion of each of the set of third layer second signal lines on the intersection portion side in a plan view is provided on the third layer,
the sixth connection via is configured to connect the fourth layer second outside line and the fourth ground portion, and
the fourth ground portion, the fourth layer second outside line, and the sixth connection via are disposed around at least part of the fourth layer second signal line.

15. A power combination/distribution device comprising:
the wiring structure for a high-frequency signal according to any one of Claims 1 to 8 and Claims 11 to 14; and
a second power combination/distribution circuit including the second signal line intersecting the first signal line and the second signal line not intersecting the first signal line by the wiring structure.

16. A power combination/distribution device comprising:
the wiring structure for a high-frequency signal according to any one of Claims 11 to 14; and
a second power combination/distribution circuit including the second signal line intersecting the first signal line and the second signal line not intersecting the first signal line by the wiring structure,
wherein the fourth layer second signal line, the set of third layer second signal lines, and the fifth connection via are provided also in the second signal line not intersecting the first signal line.

17. The wiring structure for a high-frequency signal according to any one of Claims 3 to 8,
wherein the fourth layer has a first part disposed on one side of the intersection portion with the intersection portion interposed therebetween in a plan view, and a second part disposed on another side of the intersection portion with the intersection portion interposed therebetween in the plan view.

18. The wiring structure for a high-frequency signal according to Claim 17, further comprising:
a connection portion configured to connect the first part and the second part at a position not overlapping the intersection portion in a plan view.
